# EUROPÄISCHE PATENTSCHRIFT

(11) **EP 0 931 338 B1**
(45) Veröffentlichungstag und Bekanntmachung des Hinweises auf die Patenterteilung: **28.11.2001**
(21) Anmeldenummer: 97943737.3
(22) Anmeldetag: 03.09.1997
(51) Int. Cl.: H01L 21/8238, H01L 21/336

(54) **VERFAHREN ZUR HERSTELLUNG EINES MOS-TRANSISTORS**
METHOD OF PRODUCING A MOS TRANSISTOR
PROCEDE DE PRODUCTION D'UN TRANSISTOR MOS

(30) Priorität: 27.09.1996 DE 19639875
(43) Veröffentlichungstag der Anmeldung: 28.07.1999
(73) Patentinhaber: Infineon Technologies AG, 81669 München (DE)
(72) Erfinder: LUSTIG, Bernhard, D-81737 München (DE); SCHÄFER, Herbert, D-85635 Höhenkirchen-Siegertsbrunn (DE); FRANOSCH, Martin, D-81739 München (DE)
(74) Vertreter: Zedlitz, Peter, Dipl.-Inf.
(86) Internationale Anmeldenummer: DE9701933
(87) Internationale Veröffentlichungsnummer: WO9813865

(56) Entgegenhaltungen:
- EP-A- 0 218 408
- US-A- 4 838 993
- DATABASE WPI Derwent Publications Ltd., London, GB; AN 95-012588 XP002053529 & KR 9 401 287 B (GOLDSTAR ELECTRON CO LTD) , 18.Februar 1994

## Beschreibung

MOS-Transistoren mit kurzen Kanallängen werden zur Vermeidung von Kurzkanaleffekten meist so hergestellt, daß die Source/Drain-Gebiete ein LDD (Lightly doped drain)-Profil und ein HDD (Heavily doped drain)-Profil aufweisen. Das LDD-Profil weist dabei eine geringere Dotierstoffkonzentration und eine geringere Tiefe als das HDD-Profil auf. Das LDD-Profil reicht jedoch näher an die Gateelektrode heran und bestimmt die Kanallänge des MOS-Transistors. Das HDD-Profil weist dagegen einen geringeren Anschlußwiderstand auf.

Bekannte Herstellungsverfahren von MOS-Transistoren sind in EP-A-0 218 408 und US-A-4 838 993 offenbart.

Zur Herstellung eines MOS-Transistors mit LDD- und HDD-Profil wird an der Oberfläche eines Substrats zunächst ein Gatedielektrikum und eine Gateelektrode strukturiert. Unter Verwendung des Gatestapels sowie gegebenenfalls dünnen Spacern (zum Beispiel 20 nm) als Maske wird durch Implantation das LDD-Profil erzeugt. Anschließend werden an den Flanken des Gatestapels dicke Spacer gebildet. Unter Verwendung des Gatestapels mit den dicken Spacern als Maske wird anschließend durch Implantation das HDD-Profil erzeugt (zum Beispiel T. Ohguro et al, VLSI Techn. Dig. (1996), Seite 132 oder Y. Nakahara et al, VLSI Techn. Dig. (1996), Seite 174).

Die minimal erzielbaren Tiefen der Dotierstoffprofile werden durch die Temperschritte, die zum Ausheilen und zum Aktivieren des implantierten Dotierstoffes erforderlich sind, begrenzt.

Der Erfindung liegt das Problem zugrunde, ein Verfahren zur Herstellung eines MOS-Transistors anzugeben, mit dem in der Nähe des Kanalbereichs geringere Tiefen der Dotierstoffprofile erzielbar sind.

Dieses Problem wird erfindungsgemäß gelöst durch ein Verfahren gemäß Anspruch 1. Weitere Ausgestaltungen der Erfindung gehen aus den übrigen Ansprüchen hervor.

In dem erfindungsgemäßen Verfahren umfassen die Source/Drain-Gebiete des MOS-Transistors jeweils ein erstes Teilgebiet und ein zweites Teilgebiet. Das erste Teilgebiet entspricht dem aus der Literatur bekannten HDD-Profil. Das zweite Teilgebiet entspricht dem aus der Literatur bekannten LDD-Profil. In dem erfindungsgemäßen Verfahren wird nach Bildung eines Gatestapels, der Gatedielektrikum und Gateelektrode umfaßt, eine erste Hilfsschicht mit im wesentlichen konformer Kantenbedekkung abgeschieden. Darauf wird eine zweite Hilfsschicht mit im wesentlichen konformer Kantenbedeckung abgeschieden, die selektiv zur ersten Hilfsschicht ätzbar ist. Durch anisotropes Rückätzen der zweiten Hilfsschicht werden im Bereich der Flanken der Gateelektroden Spacer gebildet. Nachfolgend werden die ersten Teilgebiete der Source/Drain-Gebiete durch Implantation erzeugt. Nach selektivem Entfernen der Spacer werden die zweiten Teilgebiete für die Source/Drain-Gebiete gebildet. Die zweiten Teilgebiete weisen eine geringere Dotierstoffkonzentration und eine geringere Tiefe als die ersten Teilgebiete auf. Ihre seitliche Ausdehnung reicht näher an die Gateelektrode heran, da die Spacer die seitliche Ausdehnung der ersten Teilgebiete begrenzt hatten.

Da in dem erfindungsgemäßen Verfahren die zweiten Teilgebiete nach den ersten Teilgebieten gebildet werden, unterliegen diese nicht den Temperaturbelastungen bei einer anschließenden Bildung der ersten Teilgebiete. Daher wird ein Auseinanderlaufen der Dotierstoffprofile der zweiten Teilgebiete im Kanalbereich vermieden. Dadurch wird ein steileres Dotierstoffprofil, das für das Kurzkanalverhalten des MOS-Transistors wünschenswert ist, erzielt.

Die zweiten Teilgebiete werden dadurch gebildet, daß nach Entfernen der Spacer die Oberfläche des Substrats in dem Bereich, in dem nachfolgend die zweiten Teilgebiete gebildet werden, angeätzt wird. Dazu wird die erste Hilfsschicht im Bereich der zweiten Teilgebiete entfernt. Durch das Anätzen der Oberfläche des Substrats in diesem Bereich entstehen Vertiefungen, die anschließend durch in situ dotierte selektive Epitaxie aufgefüllt werden. Bei der Epitaxie wächst auf der Oberfläche des Substrats ein dotiertes Gebiet auf, dessen Kristallqualität der Kristallqualität des Substrats entspricht und in dem der Dotierstoff bereits aktiviert ist. Daher ist keinerlei Temperschritt nötig, um den Dotierstoff zu aktivieren. Das Dotierstoffprofil wird durch die selektive Epitaxie vorgegeben und ist dadurch sehr steil.

Das Substrat, in dem der MOS-Transistor hergestellt wird, umfaßt mindestens im Bereich der Hauptfläche monokristallines Silizium. Vorzugsweise wird als Substrat eine monokristalline Siliziumscheibe oder ein SOI-Substrat verwendet. Im Bereich des Kanalgebiets und unterhalb davon können dabei Silizium/Germanium-Schichten vorgesehen sein.

Vorzugsweise wird die erste Hilfsschicht aus SiO₂ und/oder Si₃N₄ gebildet und die zweite Hilfsschicht aus Polysilizium. Polysilizium läßt sich mit guter Selektivität zu SiO₂ und/oder Si₃N₄ ätzen.

Bei der Herstellung von komplementären MOS-Transistoren ist es vorteilhaft, zuerst die ersten Teilgebiete für den n-Kanal-Transistor durch Implantation und anschließendes Tempern zum Ausheilen und zur Aktivierung des Dotierstoffes herzustellen. Bei der Implantation ist der Bereich für den p-Kanal-Transistor mit einer ersten Maske abgedeckt. Nach Entfernen der ersten Maske werden die ersten Teilgebiete für den p-Kanal-Transistor gebildet. Dabei wird der Bereich für den n-Kanal-Transistor mit einer zweiten Maske abgedeckt. Anschließend werden die zweite Maske und die Spacer entfernt. Der p-Kanal-Transistor wird mit einer dritten Maske abgedeckt. Die zweiten Teilgebiete für den n-Kanal-Transistor werden durch Implantation gebildet. Nach Entfernen der dritten Maske wird in einem anschließenden Temperschritt der Dotierstoff in den zweiten Teilgebieten für den n-Kanal-Transistor und in den ersten Teilgebieten für den p-Kanal-Transistor aktiviert. Danach wird eine vierte Maske gebildet, die den Bereich für den n-Kanal-Transistor abdeckt. Im Bereich des p-Kanal-Transistors wird die erste Hilfsschicht entfernt. Im Bereich für die zweiten Teilgebiete des p-Kanal-Transistors wird die oberfläche des Substrats angeätzt. Dadurch entstehen in diesem Gebiet in der Oberfläche des Substrats Vertiefungen. Anschließend werden die zweiten Teilgebiete für den p-Kanal-Transistor durch in situ dotierte selektive Epitaxie gebildet. Da in diesem Verfahren zunächst die Implantationen mit den n-dotierenden Ionen durchgeführt werden und anschließend die zweiten p-dotierten Teilgebiete gebildet werden, können, trotz der größeren Reichweite der p-dotierenden Ionen im Kristall, gleich flache Dotierstoffprofile für den n-Kanal- und den p-Kanal-Transistor erzeugt werden.

Im folgenden wird die Erfindung anhand eines Ausführungsbeispiels, das in den Figuren dargestellt ist, näher erläutert.
- Figur 1: zeigt ein Substrat mit einem Bereich für einen n-Kanal-Transistor und einem Bereich für einen p-Kanal-Transistor, nach der Bildung von Gatedielektrikum und Gateelektrode, erster Hilfsschicht und zweiter Hilfsschicht.
- Figur 2: zeigt das Substrat nach Bildung erster Teilgebiete für den n-Kanal-Transistor.
- Figur 3: zeigt das Substrat nach Bildung erster Teilgebiete für den p-Kanal-Transistor.

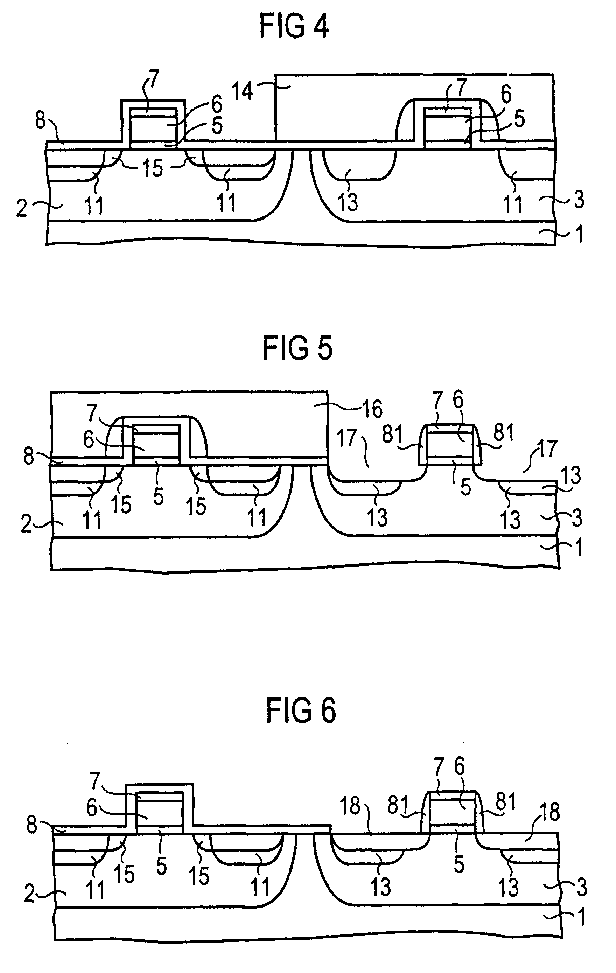

- Figur 4: zeigt das Substrat nach Bildung zweiter Teilgebiete für den n-Kanal-Transistor.
- Figur 5: zeigt das Substrat nach Anätzen der Oberfläche des Substrats im Bereich des p-Kanal-Transistors.
- Figur 6: zeigt das Substrats nach Bildung zweiter Teilgebiete für den p-Kanal-Transistor.

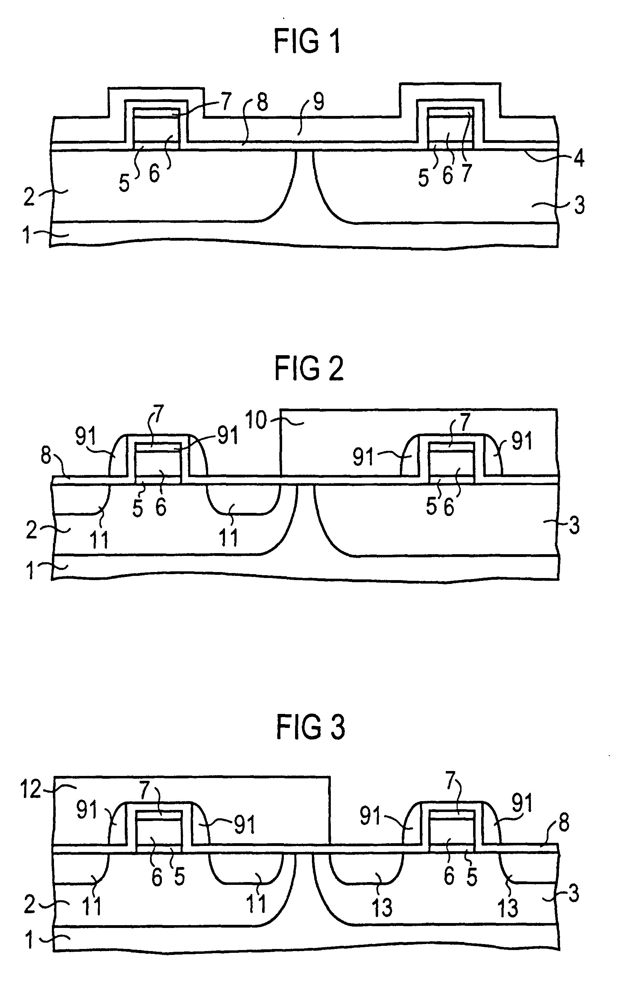

In einem Substrat 1 aus zum Beispiel monokristallinem Silizium werden in bekannter Weise eine p-dotierte Wanne 2 und eine n-dotierte Wanne 3 gebildet. Die p-dotierte Wanne 2 und die n-dotierte Wanne 3 grenzen jeweils an eine Hauptfläche 4 des Substrats 1 an. Die p-dotierte Wanne 2 ist zur Aufnahme eines n-Kanal-Transistors, die n-dotierte Wanne 3 zur Aufnahme eines p-Kanal-Transistors bestimmt (siehe Figur 1). Die Dotierstoffkonzentration in der p-dotierten Wanne 2 beträgt zum Beispiel 3 x 10¹⁷ cm⁻³, die Dotierstoffkonzentration in der n-dotierten Wanne 3 beträgt zum Beispiel 5 x 10¹⁷ cm⁻³.

Auf der Hauptfläche 4 wird für den n-Kanal-Transistor und den p-Kanal-Transistor jeweils ein Gatedielektrikum 5 zum Beispiel aus thermischem SiO₂ in einer Schichtdicke von zum Beispiel 3 nm gebildet. Ferner wird für den n-Kanal-Transistor und den p-Kanal-Transistor jeweils eine Gateelektrode aus zum Beispiel dotiertem Polysilizium mit einer Gatelänge von zum Beispiel 100 nm und eine diese bedeckende Deckschicht 7 aus zum Beispiel SiO₂ gebildet. Das Gatedielektrikum 5, die Gateelektrode 6 und die Deckschicht 7 werden zum Beispiel durch Abscheidung entsprechender Schichten und gemeinsame Strukturierung dieser Schichten erzeugt. Die Gateelektrode 6 weist eine Dicke von zum Beispiel 200 nm, die Deckschicht 7 weist eine Dicke von zum Beispiel 50 nm auf. Alternativ wird die Gateelektrode 6 mit Hilfe einer Spacertechnik gebildet.

Anschließend wird ganzflächig eine erste Hilfsschicht 8 aus zum Beispiel TEOS-SiO₂ oder Si₃N₄ abgeschieden. Die erste Hilfsschicht 8 weist eine im wesentlichen konforme Kantenbedeckung auf. Die erste Hilfsschicht 8 wird in einer Dicke von zum Beispiel 10 nm abgeschieden.

Anschließend wird eine zweite Hilfsschicht 9 mit im wesentlicher konformer Kantenbedeckung abgeschieden. Die zweite Hilfsschicht 9 wird zum Beispiel aus Polysilizium in einer Schichtdicke von 60 nm abgeschieden.

Durch anisotropes Ätzen der zweiten Hilfsschicht 9 selektiv zur ersten Hilfsschicht 8, (zum Beispiel mit HBr) werden aus der zweiten Hilfsschicht 9 Spacer 91 gebildet (siehe Figur 2). Die Spacer 91 sind, durch die erste Hilfsschicht 8 beabstandet, an den Flanken der Gateelektroden 6 angeordnet.

Es wird eine erste Maske 10 zum Beispiel aus Photolack gebildet, die die n-dotierte Wanne 3 abdeckt. Anschließend wird eine Implantation zur Bildung erster Teilgebiete 11 der Source/Drain-Gebiete des n-Kanal-Transistors durchgeführt. Dabei wirken die erste Maske 10, die Gateelektrode 6 mit der ersten Hilfsschicht 8 den Spacern 91 als Maske. Die Implantation wird zum Beispiel mit Arsen mit einer Dosis von 2 x 10¹⁵ cm⁻² bei 30 keV durchgeführt (siehe Figur 2). Die erste Maske 10 wird entfernt. Anschließend wird ein Temperschritt bei zum Beispiel 900°C, 30 Sekunden durchgeführt, um Implantationsschäden auszuheilen und den Dotierstoff in den ersten Teilgebieten 11 einzutreiben und zu aktivieren.

Es wird eine zweite Maske 12 gebildet, die die p-dotierte Wanne 2 abdeckt. Es wird eine Implantation durchgeführt zur Bildung erster Teilgebiete 13 der Source/Drain-Gebiete für den p-Kanal-Transistor. Dabei wirken die zweite Maske 12 und die Gateelektrode 6 mit der ersten Hilfsschicht 8 und den Spacern 91 als Maske. Die Implantation wird zum Beispiel mit Bor mit einer Dosis von 2 x 10¹⁵ cm⁻² und einer Energie von 10 keV durchgeführt (siehe Figur 3).

Die zweite Maske 12 wird entfernt. Anschließend werden die Spacer 91, zum Beispiel durch naßchemisches Ätzen mit Cholin, entfernt. Es wird eine dritte Maske 14 gebildet, die die n-dotierte Wanne 3 abdeckt. Zur Bildung zweiter Teilgebiete 15 für den n-Kanal-Transistor wird eine Implantation durchgeführt, bei der die dritte Maske 14 und die Gateelektrode 6 der ersten Hilfsschicht 8 als Maske wirkt. Die Implantation wird zum Beispiel mit Arsen mit einer Dosis von 2 x 10¹⁴ cm⁻² bei einer Energie von 10 keV durchgeführt. Die dritte Maske 14 wird entfernt. Anschließend wird ein Temperschritt zum Ausheilen von Implantationsschäden und zur Dotierstoffaktivierung in den ersten Teilgebieten des p-Kanal-Transistors und den zweiten Teilgebieten 15 des n-Kanal-Transistors durchgeführt. Um ein Auseinanderlaufen der Dotierstoffprofile zu vermeiden, wird dieser Temperschritt mit einem steilen Temperaturprofil durchgeführt. Er wird zum Beispiel bei 850°C, 20 Sekunden durchgeführt.

Es wird eine vierte Maske 16 aus zum Beispiel Photolack gebildet, die die p-dotierte Wanne 2 bedeckt. Durch anisotropes Ätzen werden aus dem im Bereich des p-Kanal-Transistors freiliegenden Teils der ersten Hilfsschicht 8 Spacer 81 gebildet. Die anisotrope Ätzung erfolgt zum Beispiel mit einem anisotropen CHF₃- und CF₄-Ätzprozeß.

Durch die Bildung der Spacer 81 wird die Oberfläche des Substrats im Bereich des p-Kanal-Transistors freigelegt. Nachfolgend wird die Oberfläche des Substrats angeätzt. Die Ätzung erfolgt isotrop. Dabei werden Vertiefungen 17 gebildet, die sich, wegen der isotropen Ätzung, bis unter die Spacer 81 erstrecken. Die Vertiefungen 17 können sich sogar bis unterhalb des Gatedielektrikums 6 erstrecken. Die isotrope Ätzung wird zum Beispiel mit Cholin durchgeführt. Die Tiefe der Vertiefungen 17 beträgt zum Beispiel 15 nm (siehe Figur 5).

Zur Bildung zweiter Teilgebiete 18 für den p-Kanal-Transistor wird anschließend eine in situ Bor-dotierte selektive Epitaxie durchgeführt. Dazu wird nach einer Naßreinigung, zum Beispiel in einem HF-Dip, eine Niedertemperaturreinigung bei zum Beispiel 750° im Epitaxiereaktor durch Zugabe von zum Beispiel GeH₄ oder SiH₄ durchgeführt. Dabei wird an der Oberfläche der Vertiefungen 17 befindliches natürliches Oxid abgeätzt. Anschließend wird durch selektive, in situ dotierte epitaktische Siliziumabscheidung die Vertiefung 17 aufgefüllt. Die epitaktische Siliziumabscheidung erfolgt zum Beispiel unter Verwendung eines Prozeßgases, das H₂, SiH₂Cl₂, HCl und B₂H₆ im Temperaturbereich zwischen 700°C und 800°C und im Druckbereich zwischen 10 und 100 Torr durchgeführt. Die Zugabe von B₂H₆ bewirkt, daß in die zweiten Teilgebiete 18 Bor als Dotierstoff eingebaut wird. Dadurch wird ein stufenförmiges Dotierstoffprofil erzeugt. Ein Temperschritt zum Ausheilen oder Aktivieren des Dotierstoffes ist nach der in situ dotierten Epitaxie nicht erforderlich, so daß das stufenförmige Dotierstoffprofil der zweiten Teilgebiete 18 erhalten bleibt.

## Patentansprüche

1. Verfahren zur Herstellung eines MOS-Transistors,
- bei dem auf der Hauptfläche eines Substrats, das mindestens im Bereich der Hauptfläche Silizium umfäßt, ein Gatedielektrikum (5) und eine Gateelektrode (6) gebildet werden,
- bei dem eine erste Hilfsschicht (8) mit im wesentlichen konformer Kantenbedeckung ganzflächig abgeschieden wird,
- bei dem eine zweite Hilfsschicht (9) mit im wesentlichen konformer Kantenbedeckung ganzflächig abgeschieden wird, die selektiv zur ersten Hilfsschicht (8) ätzbar ist,
- bei dem durch anisotropes Rückätzen der zweiten Hilfsschicht (9) im Bereich der Flanken der Gateelektrode (6) Spacer (91) gebildet werden,
- bei dem eine Implantation zur Bildung von ersten Teilgebieten (13) für Source/Drain-Gebiete durchgeführt wird,
- bei dem die Spacer (91) selektiv zur ersten Hilfsschicht (8) entfernt werden,
- bei dem die Oberfläche des Substrats (1) in den Bereichen (17), in denen nachfolgend zweite Teilgebiete (18) der Source/Drain-Gebiete gebildet werden, angeätzt wird,
- bei dem zweite Teilgebiete (18) für die Source/Drain-Gebiete durch in situ dotierte, selektive Epitaxie gebildet werden, wobei die zweiten Teilgebiete (18) eine geringere Dotierstoffkonzentration und eine geringere Tiefe als die ersten Teilgebiete (13) aufweisen.

2. Verfahren nach Anspruch 1,
- bei dem die erste Hilfsschicht (8) aus SiO₂ und/oder Si₃N₄ gebildet wird,
- bei dem die zweite Hilfsschicht (9) aus Polysilizium gebildet wird.

3. Verfahren nach Anspruch 1 oder 2,
- bei dem mindestens ein n-Kanal-Transistor und ein p-Kanal-Transistor gebildet werden,
- bei dem zunächst erste Teilgebiete (11) für den n-Kanal-Transistor durch Implantation und anschließendes Tempern gebildet werden, wobei der Bereich für den p-Kanal-Transistor mit einer ersten Maske (10) abgedeckt ist,
- bei dem die ersten Teilgebiete (13) für den p-Kanal-Transistor gebildet werden, wobei der Bereich für den n-Kanal-Transistor mit einer zweiten Maske (12) abgedeckt ist,
- bei dem die zweite Maske (12) und die Spacer (91) entfernt werden,
- bei dem zweite Teilgebiete (15) für den n-Kanal-Transistor durch Implantation und anschließendes Tempern gebildet werden, wobei der Bereich für den p-Kanal-Transistor mit einer dritten Maske (14) abgedeckt ist,
- bei dem nach Entfernen der dritten Maske eine vierte Maske gebildet wird, die den Bereich für den n-Kanal-Transistor abdeckt,
- bei dem im Bereich für die zweiten Teilgebiete (18) des p-Kanal-Transistors die Oberfläche des Substrats (1) freigelegt und anschließend angeätzt wird,
- bei dem die zweiten Teilgebiete (18) für den p-Kanal-Transistor durch in situ dotierte selektive Epitaxie gebildet werden.

## Claims

1. Method for the production of a MOS transistor,
- in which a gate dielectric (5) and a gate electrode (6) are formed on the main face of a substrate, which comprises silicon at least at the main face,
- in which a first auxiliary layer (8) is deposited over the whole area with essentially conformal edge coverage,
- in which a second auxiliary layer (9), which can be etched selectively with respect to the first auxiliary layer (8), is deposited over the whole area with essentially conformal edge coverage,
- in which spacers (91) are formed at the sides of the gate electrode (6) by anisotropically etching back the second auxiliary layer (9),
- in which implantation is carried out to form first subregions (13) for source/drain regions,
- in which the spacers (91) are removed selectively with respect to the first auxiliary layer (8),
- in which the surface of the substrate (1) is etched in the areas (17) where second subregions (18) for the source/drain regions are subsequently formed,
- in which second subregions (18) for the source/drain regions are formed by in situ doped selective epitaxy, the second subregions (18) having a lower dopant concentration and a smaller depth than the first subregions (13).

2. Method according to Claim 1,
- in which the first auxiliary layer (8) is formed from SiO₂ and/or Si₃N₄,
- in which the second auxiliary layer (9) is formed from polysilicon.

3. Method according to Claim 1 or 2,
- in which at least one n-channel transistor and one p-channel transistor are formed,
- in which first subregions (11) for the n-channel transistor are firstly formed by implantation and subsequent heat treatment, the area for the p-channel transistor being covered with a first mask (10),
- in which the first subregions (13) for the p-channel transistor are formed, the area for the n-channel transistor being covered with a second mask (12),
- in which the second mask (12) and the spacers (91) are removed,
- in which second subregions (15) for the n-channel transistor are formed by implantation and subsequent heat treatment, the area for the p-channel transistor being covered with a third mask (14),
- in which a fourth mask, which covers the area for the n-channel transistor, is formed after the third mask has been removed,
- in which the surface of the substrate (1) is exposed and subsequently etched in the area of the second subregions (18) of the p-channel transistor,
- in which the second subregions (18) for the p-channel transistor are formed by in situ doped selective epitaxy.

## Revendications

1. Procédé de fabrication d'un transistor MOS,
- dans lequel on forme sur la surface principale d'un substrat, qui comprend du silicium au moins dans la région de la surface principale, un diélectrique (5) de grille et une électrode (6) de grille,
- dans lequel on dépose sur toute la surface une première couche (8) auxiliaire à recouvrement de bord sensiblement conforme,
- dans lequel on dépose sur toute la surface une deuxième couche (9) auxiliaire à recouvrement de bord sensiblement conforme qui peut être attaquée chimiquement de manière sélective par rapport à la première couche (8) auxiliaire,
- dans lequel on forme par attaque chimique anisotrope en retrait de la deuxième couche (9) auxiliaire des espaceurs (91) dans la région des flancs de l'électrode (6) de grille,
- dans lequel on effectue une implantation pour former des premières sous-régions (13) pour des régions de source/drain,
- dans lequel on enlève les espaceurs (91) de manière sélective par rapport à la première couche (8) auxiliaire,
- dans lequel on attaque chimiquement la surface du substrat (1) dans les régions (17) dans lesquelles des deuxièmes sous-régions (18) des régions source/drain sont formées ensuite,
- dans lequel on forme des deuxièmes sous-régions (18) pour les régions de source/drain par épitaxie sélective, dopée in situ, les deux sous-régions (18) ayant une concentration en substance dopante plus petite et une profondeur plus petite que les premières sous-régions (3).

2. Procédé suivant la revendication 1,
- dans lequel on forme la première couche (8) auxiliaire en SiO₂ et/ou Si₃N₄,
- dans lequel on forme la deuxième couche (9) auxiliaire en polysilicium.

3. Procédé suivant la revendication 1 ou 2,
- dans lequel on forme au moins un transistor à canal de type de conductivité n et un transistor à canal de type de conductivité p,
- dans lequel on forme d'abord des sous-régions (11) pour le transistor à canal de type de conductivité n par implantation et traitement thermique qui suit, la région pour le transistor à canal de type de conductivité p étant recouverte d'un premier masque (10),
- dans lequel on forme les premières sous-régions (13) pour le transistor à canal de type de conductivité p, la région pour le transistor à canal de type de conductivité n étant recouverte d'un deuxième masque (12),
- dans lequel on enlève le deuxième masque (12) et les espaceurs (91),
- dans lequel on forme des deuxièmes sous-régions (15) pour le transistor à canal de type de conductivité n par implantation et traitement thermique qui suit, la région pour le transistor à canal de type de conductivité p étant recouverte d'un troisième masque (14),
- dans lequel, après enlèvement du troisième masque, on forme un quatrième masque qui recouvre la région pour le transistor à canal de type de conductivité n,
- dans lequel on dégage et on attaque ensuite chimiquement, dans la région pour les deuxièmes sous-régions (18) du transistor à canal de type de conductivité p, la surface du substrat (1),
- dans lequel on forme les deuxièmes sous-régions (18) pour le transistor à canal de type de conductivité p par épitaxie sélective dopée in situ.
